# EUROPEAN PATENT SPECIFICATION

(11) **EP 0 547 047 B1**
(45) Date of publication and mention of the grant of the patent: **06.12.1995**
(21) Application number: 93200698.4
(22) Date of filing: 19.01.1989
(51) Int. Cl.: B23K 1/008, H05K 3/34

(54) **Soldering apparatus of a reflow type**
Reflowartiger Lötapparat
Appareil de soudage de type à refusion

(30) Priority: 19.01.1988 JP 7432/88; 30.04.1988 JP 105478/88; 03.06.1988 JP 135566/88
(43) Date of publication of application: 16.06.1993
(62) Divisional of application: 89300492.9
(73) Proprietor: NIHON DEN-NETSU KEIKI CO., LTD., Ohta-ku Tokyo (JP)
(72) Inventor: Kondo, Kenshi, Tokyo (JP)
(74) Representative: Allam, Peter Clerk

(56) References cited:
- EP-A- 0 237 151
- EP-A- 0 251 257
- FR-A- 2 149 260
- US-A- 4 654 502

## Description

The present invention relates to a soldering apparatus of a reflow type and, more particularly, to a soldering apparatus of a reflow type in which electric parts such as chips temporarily mounted on a printed circuit board are soldered with solder preforms or solder pastes in a reflow chamber of the soldering apparatus after preheating them in a preheating chamber thereof.

A conventional soldering apparatus of the reflow type is arranged so that printed circuit boards on which chips have been temporarily mounted with solder preforms, solder pastes or adhesives are then exposed to heated air or far infrared rays to fuse or melt the solder preforms or the like, thus soldering the chips on the printed circuit boards.

One conventional soldering apparatus of the reflow type (see JP-A-63-180,368) is shown in cross-sectional side view in FIG. 4 of the accompanying drawings, in which printed circuit boards 101 with chips 102 temporarily mounted thereon with solder paste 103 are placed on a belt conveyor 105 of a metal being conveyed in a direction shown by the arrow A. The soldering apparatus 104 is provided with a first preheating chamber 106 and a second preheating chamber 107 at positions along the direction of conveyance of the belt conveyor 105 and symmetrically and vertically interposing the belt conveyor 105. The first and second preheating chambers 106 and 107 are provided each with an air inlet 106a and 107a and an air discharge outlet 106b and 107b, respectively. Air is sucked into the chambers 106 and 107 through the air inlets 106a and 107a, respectively, and the air is heated with a heater 109, such as a sheathed heater or a far infrared ray heater, mounted at their respective air discharge outlets 106b and 107b to temperatures as high as approximately 140°C, for example, below the fusion point of the solder paste 103 or the like, thus preheating the printed circuit boards 101 being conveyed in the chambers 106 and 107. The preheated printed circuit boards 101 are then conveyed to a reflow chamber 108 in the soldering apparatus 104, which is provided at a discharge exit 108b thereof with a heater 110, such as a sheathed heater or far infrared ray heater. The printed circuit boards 101 are in turn heated with air sucked from an air inlet 108a by the heater 110 at temperatures as high as 215°C, at the fusion point of the solder paste or the like or higher, thus soldering the chips 102 on the printed circuit boards 101. The heated air is discharged through the discharge outlet 108b. The preheating chambers 106 and 107 and the reflow chamber 108 are further provided each with a fan 111 which is connected through a rotary shaft 112 to each other and to a motor 113. The fans 111 then ventilate heated air in and from the chambers in a direction given by the arrow B. The soldering apparatus 104 is also provided with a cooling fan 114 for cooling the fused or melted solder paste 103 to solidify it and ensure the fixed mounting of the chips 102 to the printed circuit boards 101.

The heater 109 or 110, such as a sheathed heater or a far infrared ray heater, generates radiant heat containing far infrared rays, and the far infrared rays have the advantage that they are likely to heat even the inside of the chips 102 as compared with a heating system applying a thermal conduction of heated air. It is to be noted, however, that, as the solder paste 103 has a larger reflectance than the chips 102, the far infrared rays require a longer time for heating the solder paste 103 than for heating the chips 102, whereby the chips 102 are heated earlier than the solder paste 103 and it takes a longer time to solder the chips 102.

In a heating system using the heater 109 or 110 it is more difficult to set heating requirements than in a heating system using heated air because there are many varieties and sizes of printed circuit boards 101.

Furthermore, when a reflecting plate is provided for reflecting heat from the heater 109, 110 the reflecting surface may be coated by a flux scattering from the solder pastes 103, thereby decreasing the thermal efficiency of the heater 109, 110.

The air heated by the heaters 109 in the first and second preheating chambers 106 and 109 is ventilated downwardly by means of rotation of the ventilating fan 111, but this causes turbulence to occur. The heating by the air in a turbulent state in association with the heater 109, 110 has the tendency to cause irregularity in the heating of the printed circuit boards 101, particularly in a direction perpendicular to the direction (shown by the arrow A) of conveyance of the printed circuit boards 101, namely, in a widthwise direction thereof. In other words, a difference in temperatures is likely to occur between a middle portion of the printed circuit board 101 and both end portions in a widthwise direction thereof. If such printed circuit boards 101 are conveyed for soldering to the reflow chamber 108 where the air is likewise in a turbulent flow, the solder pastes 103 are fused in such an irregular state that a uniform soldering cannot be ensured.

Accordingly, it would be desirable to be able to prevent radiant heat, including far infrared rays generated from the heater 109, 110, from impacting directly on the printed circuit boards 101. In order to ensure good adherence of the solder paste 103 to the printed circuit boards 101, the solder paste 103 should be heated rapidly and thereafter cooled rapidly. It is to be noted, however, that, when printed circuit boards 101 and chips 102 at ambient temperatures of approximately 20°C are rapidly heated by direct contact with air heated to temperatures as high as 215°C or exposure to far infrared rays, they are likely to undergo damage-causing heat shock. Further, fluxes and volatile ingredients in the solder paste 103 are caused to evaporate upon fusion by heating and air bubbles may be formed within the solder paste 103. A portion of such air bubbles may remain within the solder paste 103, causing it to become porous and thus decreasing its intensity. Furthermore, air bubbles which are generated at a surface portion of the solder paste 103 tend to scatter fused solder paste 103 which then adheres to wiring of the chips 102 and printed circuit boards 101, damaging the chips 102 and short-circuiting the wiring. These disadvantages can impair the quality of the soldered printed circuit boards 101.

In the conventional soldering apparatus 104, the air heated in the preheating chambers 106, 107 and the reflow chamber 108 and withdrawn therefrom is then circulated back to the ventilating fans 111 through flow passages disposed in the chambers 106, 107, 108 after the air has heated the solder paste 103 in those chambers. It is to be noted that fusion of the solder paste 103 with the heated air generates smoke or fumes and odorous gases. The smoke and gases are circulated by the ventilating fans 111 to the preheating chambers 106, 107 and the reflow chamber 108 together with the heated air through the flow passages. As a matter of course, the smoke and gases cause dirt to adhere on the inner wall surfaces of the chambers 106, 107, 108, the heaters 109, 110, the fans 111 and the withdrawing duct 115. Furthermore, a portion of the smoke and gases is withdrawn to the atmosphere outside the soldering apparatus 104, impairing its operational circumstances, causing pollution and so on.

The present invention has been made from a consideration of the above-discussed problems of conventional soldering apparatus of the reflow type, and has for its object to provide such an apparatus which permits better control of the heating of the printed circuit boards, and which also in preferred embodiments can be adapted both to prevent direct impact of radiant heat onto the printed circuit boards and/or permit ready removal of smoke, fumes and odorous gases generated within the apparatus.

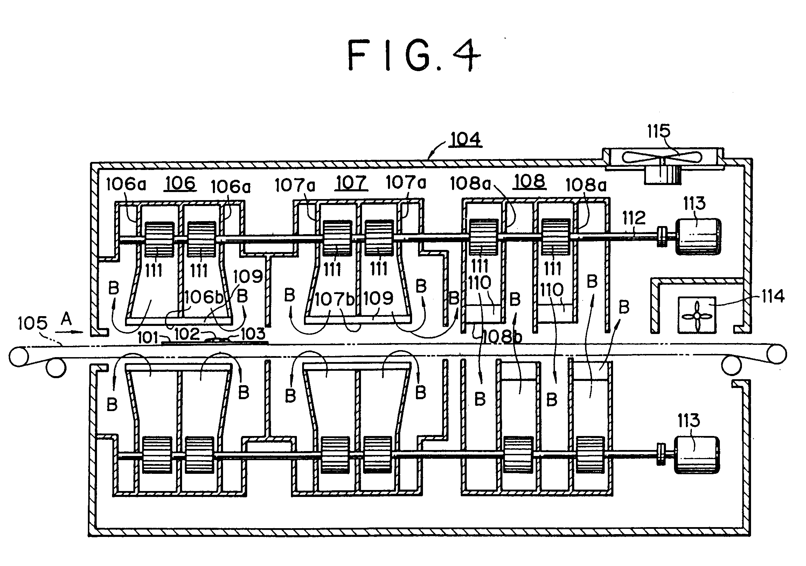

The soldering apparatus of a reflow type of the present invention, like that of FIG. 4, comprises a conveyor means for conveying a printed circuit board on which a chip is temporarily mounted with a solder paste successively through at least one preheating chamber for preheating the printed circuit board and a reflow chamber for soldering the chip on the printed circuit board by fusion of the solder paste. Each of the preheating and reflow chambers has a fan for ventilating air in the chamber and heating means for heating air in the chamber.

The soldering apparatus of the present invention is characterized in that the heating means in each of the preheating and reflow chambers comprises a plurality of heaters mounted at an air outlet portion of the chamber in parallel to the direction of movement of the conveyor means for progressively heating the printed circuit board as it is conveyed through the apparatus.

Furthermore, the apparatus of the present invention is also characterized in that each of the heaters is separated from adjacent heaters in each chamber by partition members whereby streams of heated air at a predetermined temperature differential from adjacent streams may be directed onto the printed circuit board, whereby the heating of the printed circuit board may be controlled in a predetermined manner.

With the above arrangement, the heated air in the preheating chamber and in the reflow chamber is circulated forcibly by operation of the ventilating fans, while the flow of the heated air in a turbulent state is transformed into a laminar flow upon passage between the partition members. The air is heated at predetermined temperature differentials in a gradient manner by the heaters, thus gradually heating the printed circuit board being conveyed to higher temperatures from the inlet to the outlet of the conveyor means and removing thoroughly air bubbles generating upon fusion of the solder pastes.

The preferred embodiments of the soldering apparatus of the present invention further comprise a screening member mounted along the heaters of the preheating and reflow chambers so as to prevent direct radiation of radiant heat into the chambers and onto the printed circuit boards.

In one preferred embodiment of the present invention the apparatus further comprises a combustion unit with a catalyst for removing smoke or fumes and odorous gases generated in the preheating chamber and optionally the reflow chamber as well, the combustion unit being connected at its inlet and outlet sides to the preheating chamber, and optionally the reflow chamber as well. This arrangement permits removal of the smoke or fumes and the gases generated in the preheating chamber and in the reflow chamber through a combustion action by direct contact thereof with a catalyst in the combustion unit. The air from which the smoke or fumes and the gases have been removed is returned to the preheating and reflow chambers.

Preferred embodiments of soldering apparatus in accordance with the present invention will now be described in detail with reference to the accompanying drawings, in which:
FIG. 1 is a cross-sectional side view showing one example of soldering apparatus according to the present invention;
FIG. 2 is a cross-sectional side view showing another example of soldering apparatus according to the present invention;
FIG. 3 is a graph showing a relationship of conveyance time of a printed circuit board with a temperature; and
FIG. 4 is a cross-sectional side view showing a conventional soldering apparatus.

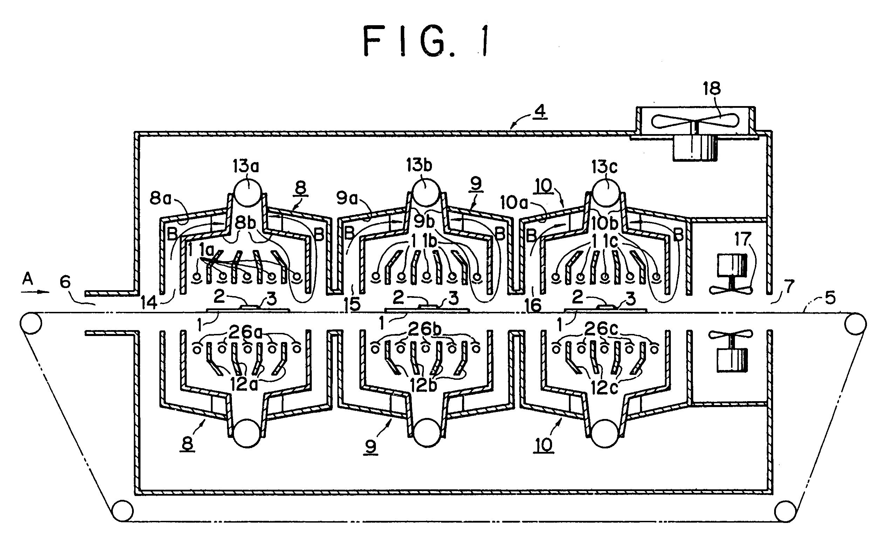

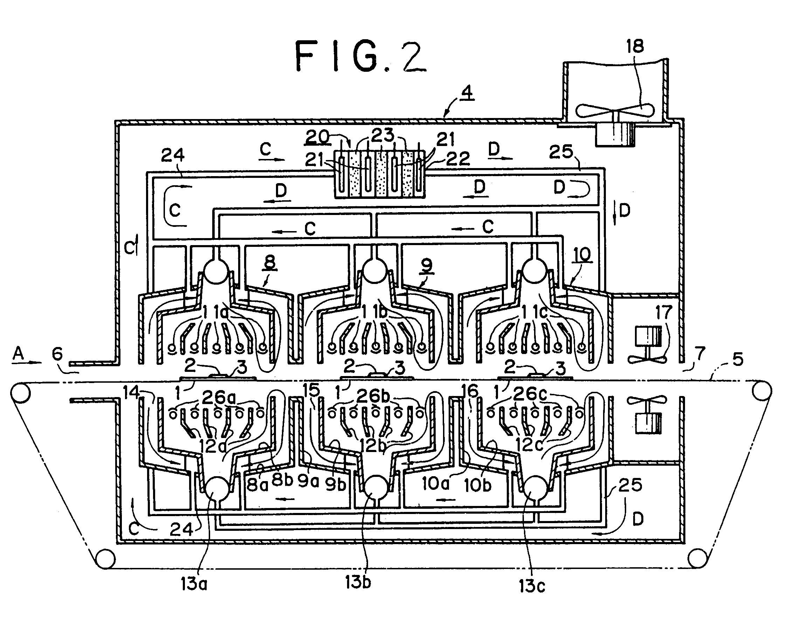

Referring to FIGS. 1 and 2, the illustrated soldering apparatus 4 of the reflow type according to the present invention comprises a first preheating chamber 8, a second preheating chamber 9, and a reflow chamber 10. Each of the chambers is shown to be substantially identical to each other, and identical elements thereof are provided with identical numerals but with different reference symbols "a", "b" and "c", respectively.

Each of the first and second preheating chambers 8 and 9 and the reflow chamber 10 is disposed symmetrically at vertical positions so as to interpose a belt conveyor 5, made out of a metal network for example, which conveys a printed circuit board 1 with a chip 2 mounted with solder paste 3 from the first preheating chamber 8 through the second preheating chamber 9 to the reflow chamber 10.

As shown in FIGS. 1 and 2, a plurality of heaters 11a are disposed horizontally at an outlet portion of the first preheating chamber 8 in parallel to the direction of conveyance of the belt conveyor 5 shown by the arrow A so as to heat the printed circuit boards 1 in such a manner that air is progressively heated in the direction shown by the arrow A from an inlet 6 to an outlet 7 of the soldering apparatus 4. This arrangement of the heaters permits air to be heated from virtually ambient temperature at the inlet portion of the chamber to the fusion point of the solder paste 3 in virtually a linear manner from the first preheating chamber 8 through the second preheating chamber 9 to the reflow chamber 10. Between each of the heaters 11a is mounted a partition plate 12a in order to retain air heated by the respective heater 11a in a space defined between the inner wall 8b of the chamber and the adjacent partition plate 12a or between the adjacent partition plates 12a at a predetermined temperature differential from the adjacent space or spaces. Thus, the partition plates between the heaters serve to transform a flow of the heated air in a turbulent state in the chambers into a laminar flow, so as to obtain a predetermined temperature differential between adjacent spaces separated and defined by the partition plates.

Underneath each of the heaters 11a is provided a screening plate 26a such that radiant heat generated from the heater 11a is not radiated directly onto the chips 2 and the printed circuit boards 1.

With this arrangement, as shown in FIGS. 1 and 2, the first preheating chamber 8 of the soldering apparatus 4 is designed such that the printed circuit boards 1 conveyed from the inlet 6 thereinto are heated by air heated by a series of the heaters 11a to progressively higher temperatures and blown by a ventilating fan 13a onto the solder pastes 3 in the direction shown by the arrow B so as to cause the solder paste 3 to gradually scatter fluxes and volatile ingredients generated from the solder pastes 3 as the belt conveyor 5 moves in the conveying direction A. The heated air blown onto the printed circuit boards 1 is then returned for circulation to the ventilating fan 13a through a flow passage 14 defined by the outer wall 8a and the inner wall 8b of the first preheating chamber 8 in the direction shown by the arrow B.

As shown in FIGS. 1 and 2, the second preheating chamber 9 and the reflow chamber 10 are constructed in substantially the same manner as the first preheating chamber 8. It is thus to be noted that fluxes and volatile ingredients generated from the solder paste 3 are gradually scattered and thoroughly removed until the printed circuit boards 1 reach the reflow chamber 10, whereby no bubbles are left in the solder paste 3.

The printed circuit boards 1 with the chips 2 soldered thereon are then conveyed out of the reflow chamber 10 and cooled by a cooling fan 17.

Exhaust air and gases in the soldering apparatus 4 are withdrawn by an exhaust fan 18 mounted on an upper wall of the soldering apparatus 4.

Referring now to FIG. 2, the soldering apparatus 4 has substantially the same structure as the soldering apparatus 4 shown in FIG. 1, described hereinabove, with the exception that a combustion unit 20 is included for removing smoke or fumes and odorous gases. The combustion unit 20 comprises a heater 21, a temperature governing device 22, and a catalyst 23, and it may be in a form such as a frame with a wire net mounted inside so as to accommodate the catalyst 23 of an oxidizable type in a granular state, such as a platinum-alumina system, for burning the smoke or fumes and gases for oxidation. The heater 21 is designed so as to heat the catalyst 23 at temperatures optimal to burn the smoke or fumes and gases, and the temperature governing device 22 is designed so as to regulate the temperatures around approximately 250°C for optimal combustion. The combustion unit 20 communicates at its inlet side through a pipe 24 with the flow passage 14a of the first preheating chamber 8, the flow passage 14b of the second preheating chamber 9, and the flow passage 14c of the reflow chamber 10. The air containing the smoke or gases is led to the combustion unit 20 through the pipe 24 in the direction shown by the arrow C. The combustion unit 20 communicates at its outlet side through a pipe 25 with the ventilating fan 13a of the first preheating chamber 8, the fan 13b of the second preheating chamber 9, and the fan 13c of the reflow chamber 10, and the air from which the smoke and gases have been removed is then returned to the first and second preheating chambers 8 and 9 and the reflow chamber 10 in the direction shown by the arrow D.

The temperature of the heated air to be fed to the ventilating fan 13a from the combustion unit 20 is adjusted by opening or closing a damper (not shown) mounted in each of the flow passages 14, 15 and 16. A surplus of heated air is exhausted outside with an exhaust fan 18 through an exhaust duct 19 disposed on an upper portion of the soldering apparatus 4.

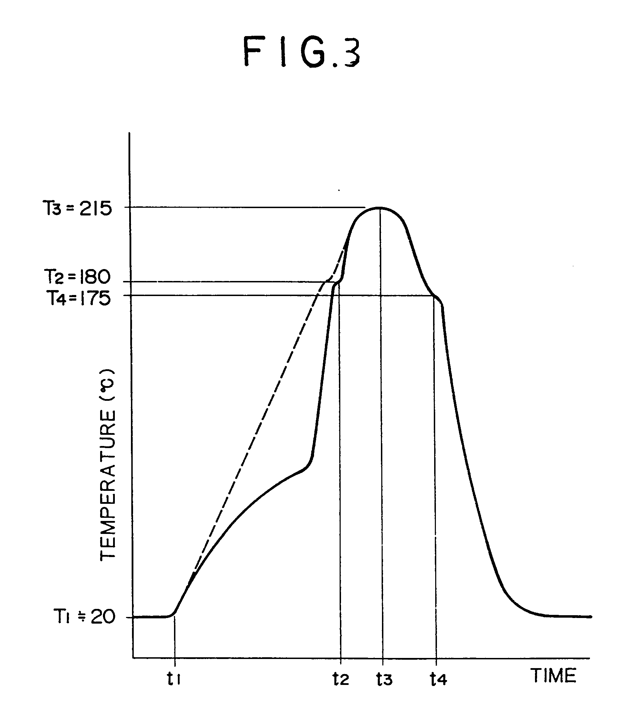

FIG. 3 is a view showing typical relationships between the conveyance times of a printed circuit board with temperatures, in which the solid line represents the conventional temperature characteristic and the broken lines represent temperature characteristic according to an example of the present invention. In FIG. 3, t₁ is the time at which the solder paste 3 starts being heated by hot air heated by the heater 11, t₂ is the time at which the soldering starts in the reflow chamber 10, t₃ is the time at which the solder paste 3 reaches a maximum temperature and the cooling starts, t₄ is the time at which fused solder paste 3 starts solidifying, T₁ is the temperature of the printed circuit boards 1 and the solder pastes 3 at ambient temperature (approximately 20°C), T₂ is the temperature (approximately 180°C) at which the solder paste 3 fuses, T₃ is the maximum temperature (approximately 215°C), and T₄ is the temperature (approximately 175°C) at which the solder pastes 3 start solidifying.

As shown in FIG. 3, the temperature of the printed circuit boards 1 rises in a linear relationship from T₁ to T₂ during a period of time from t₁ to t₂ in the example in accordance with the invention, thus preheating them to a sufficient level. This permits bubbles generated at surface portions of the solder paste 3 to scatter gradually without scattering fused solder paste 3, and eventually all bubbles to be fully removed.

The illustrated arrangements of the soldering apparatus of the present invention thus have a number of advantages. In particular, the circuit boards may be heated in a predetermined manner, thus gradually scattering bubbles generated on the surface of the solder paste and preventing the solder paste from adhering to the chips and the wiring. A thorough removal of air bubbles generated in the fused solder paste is obtainable, thereby increasing the intensity of soldering of the chips on the printed circuit boards and providing printed circuit boards of higher quality.

The combustion unit of the modified arrangement shown in FIG. 2 minimizes the amount of dirt which adheres to the printed circuit boards being conveyed through the reflow chamber, the inner walls of the chambers, the ventilating fans, the exhaust fans, the ducts, and so on, and also improves operation circumstances. This is also advantageous from the viewpoint of pollution control.

The combustion unit to be included in the soldering apparatus of this type may be of a simplified structure, thus reducing the cost of pollution control.

In the soldering apparatus which incorporates the combustion unit, the heated air is re-used by circulation after removal of smoke and gases, thus minimizing the degree of oxidation in the solder pastes and providing printed circuit boards of higher quality.

## Claims

1. A soldering apparatus of a reflow type, comprising:
a conveyor means (5) for conveying a printed circuit board (1) on which a chip (2) is temporarily mounted with a solder paste (3) successively through a preheating chamber (8;9) for preheating the printed circuit board and a reflow chamber (10) for soldering the chip on the printed circuit board by fusion of the solder paste,
each of said chambers (8;9;10) having a fan (13a;13b;13c) for ventilating air in the chamber and heating means (11a;11b;11c) for heating air in the chamber,
characterized in that:
said heating means in each of said chambers (8;9;10) comprises a plurality of heaters (11a;11b;11c) mounted at an air outlet portion of the chamber in parallel to the direction of movement (A) of said conveyor means (5) for progressively heating the printed circuit board (1) as it is conveyed through the apparatus,
and in that each of said heaters (11a;11b;11c) is separated from adjacent heaters in each chamber by partition members (12a;12b;12c) whereby streams of heated air at a predetermined temperature differential from adjacent streams may be directed onto the printed circuit board (1), whereby the heating of the printed circuit board (1) may be controlled in a predetermined manner.

2. A soldering apparatus as claimed in Claim 1, further comprising a screening member (26a;26b;26c) mounted along the heaters (11a;11b;11c) of the preheating and reflow chambers (8;9;10) so as to prevent direct radiation of radiant heat into the chambers and onto the printed circuit board.

3. A soldering apparatus as claimed in Claim 1 or Claim 2, further comprising a combustion unit (2) with a catalyst (23) for removing smoke and odorous gases generated in the preheating chamber (8;9) and for circulating heated, cleaned air to said preheating chamber (8;9).

4. A soldering apparatus as claimed in Claim 3, wherein said combustion unit (20) is also adapted to remove smoke and odorous gases generated in the reflow chamber (10) and to circulate heated, cleaned air to said reflow chamber.

## Patentansprüche

1. Lötvorrichtung eines Typs der Aufschmelzlötung, umfassend:
eine Zuführeinrichtung (5), die eine bedruckte Leiterplatte (1), auf der mit einer Lötpaste (3) vorübergehend ein Chip (2) angebracht ist, nacheinander durch die Vorwärmekammer (8; 9) zum Vorwärmen der bedruckten Leiterplatte und durch eine Aufschmelzlötkammer (10) zum Auflöten des Chips auf die Leiterplatte durch Schmelzen der Lötpaste, befördert,
wobei jede dieser Kammern (8; 9; 10) über einen Ventilator (13a; 13b; 13c) zur Ventilierung der Luft in der Kammer und ein Heizmittel (11a; 11b; 11c) zur Erwärmung der Luft in der Kammer verfügt,
dadurch gekennzeichnet, daß
das Heizmittel in jeder der Kammern (8; 9; 10) eine Vielzahl an Heizvorrichtungen (11a; 11b; 11c) umfaßt, die an einem Luftauslaßteilstück der Kammer parallel zur Bewegungsrichtung (A) der Zuführeinrichtung (5) angebracht sind, um die bedruckte Leiterplatte (1) schrittweise zu erwärmen, während diese durch die Vorrichtung befördert wird,
und daß jeder der Heizvorrichtungen (11a; 11b; 11c) von den angrenzenden Heizvorrichtungen in jeder einzelnen Kammer durch Trennbleche (12a; 12b; 12c) getrennt ist, wobei Ströme erwärmter Luft mit einer vorherfestgelgten Temperatur, die sich von der angrenzender, Strömen unterscheidet, direkt auf die bedruckte Leiterplatte (1) gerichtet werden kann und dadurch die Erwärmung der bedruckten Leiterplatte (1) auf vorherfestgelegte Art und Weise kontrolliert werden kann.

2. Lötvorrichtung nach Anspruch 1, die ferner eine Trennvorrichtung (26a; 26b; 26c) umfaßt, die entlang der Heizvorrichtung (11a; 11b; 11c) der Vorwärme- und Auschmelzlötkammern (8; 9; 10) angebracht ist, um eine direkte Strahlung der Strahlungswärme in die Kammer und auf die bedruckte Leiterplatte zu verhindern.

3. Lötvorrichtung nach Anspruch 1 oder 2, die ferner eine Verbrennungseinheit (2) mit einem Katalysator (23) zur Beseitigung von Rauch oder riechenden Gasen, die in der Vorwärmekammer (8; 9) entstanden sind, und zur Zirkulation erwärmter, gereinigter Luft zur Vorwärmekammer (8; 9) umfaßt.

4. Lötvorrichtung nach Anspruch 3, wobei die Verbrennungseinheit (20) ferner so angepaßt ist, daß sie Rauch und riechende Gase beseitigt, die in der Aufschmelzlötkammer (10) entstanden sind, und für die Zirkulation erwärmter, gereinigter Luft zur Aufschmelzlötkammer sorgt.

## Revendications

1. Appareil de soudage de type à refusion comprenant :
un dispositif de transport (5) pour transporter une carte à circuit imprimé (1), sur laquelle une puce (2) est provisoirement montée avec une pâte à souder (3), successivement à travers une chambre de préchauffage (8; 9) pour le préchauffage de la carte à circuit imprimé et une chambre de refusion (10) pour le soudage de la puce sur la carte à circuit imprimé par fusion de la pâte à souder,
chacune desdites chambres (8 ; 9 ; 10) possédant un ventilateur (13a ; 13b; 13c) pour ventiler la chambre et un dispositif de chauffage (11a ; 11b; 11c) pour chauffer l'air dans la chambre, caractérisé en ce que :
- ledit dispositif de chauffage dans chacune desdites chambres (8; 9; 10) comprend une pluralité d'organes de chauffage (11a ; 11b ; 11c) montés à proximité d'une sortie d'air de la chambre, parallèlement à la direction du mouvement (A) dudit dispositif de transport (5) afin de chauffer progressivement la carte à circuit imprimé (1) au fur et à mesure de son déplacement à travers l'appareil,
- et en ce que chacun desdits organes de chauffage (11a ; 11b ; 11c) est séparé des organes de chauffages adjacents dans chaque chambre par des parois de séparation (12a ; 12b ; 12c) de sorte que les courants d'air chauffés et présentant des différentiels de température prédéterminés vis-à-vis des courants adjacents, peuvent être dirigés sur la carte à circuit imprimé (1), de sorte que le chauffage de la carte à circuit imprimé (1) peut être contrôlé d'une manière prédéterminée.

2. Appareil de soudage selon la revendication 1 comprenant en outre des écrans (26a ; 26b ; 26c) montés à proximité des organes de chauffage (11a ; 11b ; 11c) des chambres de préchauffage et de refusion (8 ; 9 ; 10) pour empêcher le rayonnement direct de la chaleur rayonnante dans les chambres et sur la carte à circuit imprimé.

3. Appareil de soudage selon la revendication 1 ou la revendication 2, comprenant en outre une unité de combustion (20) avec un catalyseur (23) pour l'élimination de la fumée et des gaz odorants produits dans la chambre de préchauffage (8 ; 9) et pour la circulation d'air chauffé, nettoyé vers ladite chambre de préchauffage (8 ; 9).

4. Appareil de soudage selon la revendication 3, dans lequel ladite unité de combustion (20) est agencée pour éliminer la fumée ou les gaz odorants produits dans la chambre de refusion (10) et pour faire circuler de l'air chaud, nettoyé vers ladite chambre de refusion.
